Europäisches Patentamt

European Patent Office

Office européen des brevets

(11) Veröffentlichungsnummer: **0 127 689**
**B1**

(12) **EUROPÄISCHE PATENTSCHRIFT**

(45) Veröffentlichungstag der Patentschrift:
26.08.87

(21) Anmeldenummer: 83104956.4

(22) Anmeldetag: 19.05.83

(51) Int. Cl.⁴: **H 05 K 3/10**

(54) Verfahren zum Herstellen von gedruckten Schaltungen mit in das Isolierstoffsubstrat eingebetteten metallischen Leiterzugstrukturen.

(43) Veröffentlichungstag der Anmeldung:
**12.12.84 Patentblatt 84/50**

(45) Bekanntmachung des Hinweises auf die Patenterteilung:
**26.08.87 Patentblatt 87/35**

(84) Benannte Vertragsstaaten:
**DE FR GB**

(56) Entgegenhaltungen:
**DE - A - 2 305 883**
**DE - A - 2 708 945**

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk,
N.Y. 10504 (US)**

(84) Benannte Vertragsstaaten: **FR GB**

(72) Erfinder: **Greschner, Johann, Dr. Dipl.-Phys.,
Tiergartenweg 14, D-7401 Pliezhausen (DE)**
Erfinder: **Schwerdt, Friedrich, Nelkenstrasse 23,
D-7033 Herrenberg 1 (DE)**
Erfinder: **Trumpp, Hans Joachim, Dr. Dipl.-Phys.,
Reichenbergerstrasse 32, D-7000 Stuttgart 80 (DE)**

(74) Vertreter: **Kreidler, Eva-Maria, Dr. rer. nat., Schönaicher
Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft ein Verfahren zum Herstellen von gedruckten Schaltungen, bei denen metallische Leiterzugstrukturen in ein Isolierstoffsubstrat eingebettet sind und Vorder- und Rückseite mittels durchmetallisierter Löcher elektrisch leitend verbunden sind.

Bei der Herstellung von Leiterplatten werden wegen des Erfordernisses der hohen Leiterbahndichte die Leiterbahnen heute üblicherweise auf mehrer Ebenen verteilt, und die Signalebenen werden zusammen mit der erforderlichen Anzahl von Stromversorgungsebenen zu einer Mehrlagenschaltung zusammengefasst. An die Fertigung von Leiterplatten werden heute wegen der hohen Dichte der Verdrahtung bezüglich der angewendeten Materialien und Verfahren besonders hohe Anforderungen gestellt.

Ein- oder auch mehrlagige Leiterplatten wurden bisher im wesentlichen nach zwei Methoden hergestellt. Bei der subtraktiven Methode ist das Ausgangsmaterial ein kupferkaschiertes Halbzeug, d.h. eine z.B. glasfaserverstärkte Epoxidharzplatte, auf die ein- oder beidseitig eine z.B. 35 μm dicke Kupferfolie auflaminiert ist. Um eine gute Haftfestigkeit dieser Kupferkaschierung zu erreichen, ist der Isolierstoffträger vor dem Laminieren noch nicht vollständig auspolymerisiert. Die Kupferfolie selbst, die bei hohen Stromdichten auf einem Träger galvanisch abgeschieden wird, weist einseitig eine sehr rauhe Oberfläche auf, die durch chemische Nachbehandlung mit Haftvermittlern noch weiter gesteigert wird. Beim Laminieren liegt diese rauhe Seite der Kupferfolie auf dem Isolierstoffträger, der durch den Druck und die Wärmezufuhr beim Laminiervorgang nochmals zähflüssig wird, auf. Als Ergebnis des Laminiervorgangs werden zwei vielfach miteinander verzahnte Grenzschichten erhalten.

Beim Weiterverarbeiten werden mehrere auf ein bestimmtes Format geschnittene, kupferkaschierte Trägerplatten zu einem Paket zusammengepresst und Löcher für Durchkontaktierungen mit numerisch gesteuerten Automaten gebohrt. Die Löcher werden anschliessend durch Schleifen entgratet. Diese entgrateten Bohrungen werden metallisiert, d.h. durchkontaktiert, indem rein chemisch eine Basisschicht aus Kupfer an den Bohrungswandungen niedergeschlagen wird, die galvanisch verstärkt wird. Die Oberfläche der kupferkaschierten Trägerplatten wird durch eine geeignete Vorbehandlung für den eigentlichen Leiterbahndruck vorbereitet. Hierzu wird die Oberfläche mit einem Photoresist beschichtet und der Konfiguration der Leiterbahnen entsprechend belichtet. In einem darauffolgenden Entwicklungsprozess lässt sich der Photoresist an den nichtbelichteten Stellen entfernen. Die Leiterplatte durchläuft dann eine Ätzanlage, die die Kupferschicht ablöst, wo sie nicht mehr durch den Photoresist geschützt ist. Der restliche Resist wird anschliessend mit einem Lösungsmittel entfernt. Auf der Epoxidharz-Isolierschicht befindet sich jetzt nur noch die gedruckte Schaltung.

Nachteilig an der subtraktiven Methode ist, dass eine relativ dicke Kupferkaschierung aufgebracht wird, die dann durch Ätzen zum grössten Teil wieder abgelöst werden muss. Dadurch wird dieses Verfahren für feine Verdrahtungsnetzwerke unwirtschaftlich. Ausserdem führen starke Unterätzungen zu einer Limitierung der Leiterzuggeometrie. Es war daher wünschenswert, anstelle der etwa 35 μm starken Kupferkaschierung eine wesentlich dünnere Kupferkaschierung verwenden zu können. Bei dem sogenannten additiven Verfahren dient eine nur etwa 5 μm dicke Kupferfolie als Ausgangsschicht für die Leiterzugebene. Da sich diese empfindliche Folie für sich allein kaum handhaben lässt, verwendet man für den Laminierprozess eine zweischichtige Kupferfolie, wobei die dickere Trägerfolie nach dem Laminieren wieder abgezogen wird. Auf die auflaminierte, dünne Kupferfolie von etwa 5 μm Dicke wird ein Photoresistfilm auflaminiert, der in üblicher Weise über eine Maske belichtet wird. Die Maske ist in diesem Verfahren so ausgebildet, dass der Photoresistfilm beim Entwickeln an den Stellen abgelöst wird, an denen die Kupferleitungen entstehen sollen. In einem stromlosen Kupferbad lässt man anschliessend auf den freigelegten Kupferleitungen weiteres Kupfer chemisch aufwachsen. Die Leiterzüge wachsen dabei praktisch in einem Graben auf, der links und rechts von der Photoresistfolie begrenzt wird. Zum Schutz der Kupferleitungen bringt man anschliessend eine Zinnschicht auf. Dann wird die Photoresistmaske entfernt. In dem folgenden Ätzprozess wird die dünne Kupferfolie an den Stellen, an denen sich keine mit Zinn geschützten Leiterzüge befinden, abgelöst. Anschliessend wird die Zinnschicht wieder entfernt.

Sowohl dem Subtraktiv- wie auch dem Additivverfahren gemeinsam ist die Verwendung von Negativ-Photoresistmaterialien, die entweder als Flüssigkeit oder als Resistfolie aufgetragen werden. Die Verwendung eines Positiv-Photoresists wäre sehr wünschenswert, bisher ist jedoch kein Positiv-Photoresitsystem bekannt, das den Bedingungen der nachfolgenden galvanischen Prozesse hinreichend genügt.

Aufgabe der Erfindung ist daher die Bereitstellung eines Verfahrens zur Herstellung einer Leiterzugverdrahtung, bei dem in vorteilhafter Weise Positiv-Resistmaterialien verwendet werden können und die Muster der Leiterzugstrukturen in das Epoxidharzlaminat eingeätzt werden, so dass als Resultat des Verfahrensablaufs eine in das Epoxidharzlaminat eingebettete Leiterzugverdrahtung mit planarer Oberfläche der Laminate erhalten wird.

Die Aufgabe der Erfindung wird gelöst durch ein Verfahren gemäss Patentanspruch 1.

Aus der deutschen Offenlegungsschrift 27 08 945 ist zwar ein Verfahren zur Herstellung eingeebneter Leiterplatten mit durchkontaktierten Bohrungen bekannt, bei dem bei Druckanwendung die in den Bohrungen aufgebrachten metallischen Durchverbindungen nicht zusammengedrückt werden können und es zu keiner Unterbrechung in der Stromführung kommen soll. Gemäss diesem Verfahren wird ein Leiterbild subtraktiv durch Abätzen der Metallkaschierung positiv bedruckter Isolierstoffträger und Aufbringen eines Ätzschutzmetalls auf die Leiterbahnen hergestellt. Anschliessend werden die so hergestellten Leiterbahnen in die Isolierstoffplatte eingepresst. Danach erfolgt das Bohren der Löcher, die plattiert werden sollen und das Aufbringen einer Leitschicht durch chemische Metallisierung der gesamten Plattenoberfläche und der Lochwandungen. Anschliessend wird die Plattenoberfläche mit galvanofestem Lack bedruckt, und es erfolgt eine galvanische Verstärkung der Lochwandungen und gegebenenfalls der Lötaugen und das Aufbringen eines Ätzschutzmetalls. Nach dem Abwaschen des galvanofesten Lacks wird die Leitschicht abgeätzt. Durch die Verfahrensfolge wird erreicht, dass die metallische Leitschicht der durchplattierten Bohrungen keinerlei mechanischer Beanspruchung ausgesetzt wird. Mit dem Verfahren gemäss der Offenlegungsschrift können jedoch die heute gewünschten hohen Leiterzugdichten bei Leiterplatten nicht hergestellt werden. Ausserdem handelt es sich bei dem beschriebenen Verfahren um ein Subtraktivverfahren, bei dem Negativ-Photoresistmaterialien Anwendung finden.

Das erfindungsgemässe Verfahren wird anhand der speziellen Beschreibung und anhand der Zeichnung näher erläutert. Dabei zeigen die vier Figuren rein schematisch den Fertigungsablauf nach dem erfindungsgemässen Verfahren in verschiedenen Schritten.

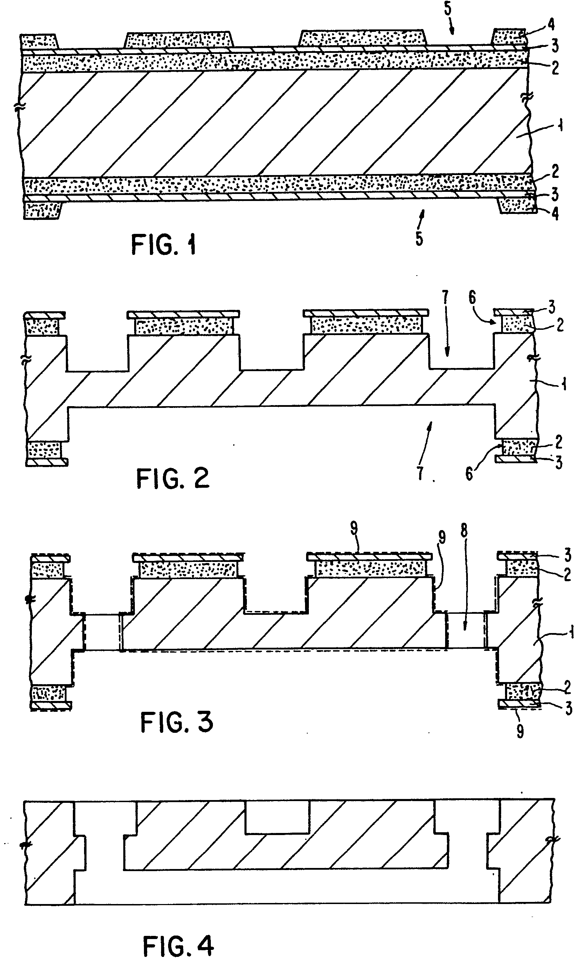

Gemäss Fig. 1 wird ein mit Epoxidharz getränktes Glasgewebe, dessen Epoxidharzanteil nur bis zu einem gewissen Grad ausgehärtet wurde und das als Prepreg im B-Zustand bezeichnet wird, als Trägermaterial verwendet. Im einzelnen wird ein vierlagiges Prepreg aus Epoxidharz zwischen zwei Polyvinylfluoridfolien (nicht dargestellt), die unter dem Handelsnamen Tedlar erhältlich sind, in einer Laminierpresse bei etwa 190 °C heiss verpresst, wobei ein Produkt mit völlig glatter Oberfläche erhalten wird. Nach dem Verpressen werden die Laminate auf eine definierte Grösse zugeschnitten. Das Prepreg 1 wird beidseitig mit einer Ablöseschicht 2 aus Positiv-Photoresistmaterial beschichtet. Als Positiv-Photoresistmaterialien kommen beispielsweise der von der Firma Shipley erhältliche AZ 1350J Resist, welcher ein Phenolformaldehydharz mit einem Gehalt an 3,4-Dihydroxybenzophenon-4-[naphthochinon-1,2-diazid-2-]sulfonat als reaktivem Bestandteil ist oder der von der gleichen Firma erhätliche AZ 111 Photoresist auf der Basis von Carboxymethyläthern von Formaldehydharzen mit o-Chinondiazid als reaktivem Bestandteil in Frage. Die Beschichtung des Laminats 1 wird zweckmässigerweise in der Weise vorgenommen, dass das Laminat senkrecht beispielsweise in eine 1:3 mit Methylglykol oder mit N-Butylacetat, Xylol und Äthylglykolacetat verdünnte Lösung von Shipley AZ 1350J Photoresist mit definierter Viskosität getaucht und mit definierter Geschwindigkeit wieder herausgezogen wird, wobei Schichtdicken im Bereich von 2 bis 4 μm, mit denen gute Ergebnisse erzielt werden können, hergestellt werden. Das Trocknen der Schichten 2 aus Photoresist erfolgt in einem Umluftofen bei etwa 80 bis 100 °C während 20 Minuten. Im nächsten Schritt wird eine Sperrschicht 3, vorzugsweise aus einem Metall, das sich leicht kalt aufsputtern oder aufdampfen lässt, aufgebracht. Als solches wird beispielsweise Aluminium in einer Schichtdicke von etwa 200 bis 500 nm in einer Aufdampfanlage mit einer Elektronenstrahlkanone innerhalb einer Zeit von etwa 200 Sekunden ohne Substratheizung aufgedampft. Diese Aluminiumschicht wiederum wird mit einer Schicht 4 aus einem Positiv-Photoresistmaterial beschichtet. Als solche sind wiederum der zuvor beschriebene AZ 1350J Photoresist oder AZ 111 Photoresist der Firma Shipley geeignet. Der unverdünnte Photoresist wird in einem Tauchverfahren in einer Schichtdicke von etwa 3 bis 4 μm aufgetragen und wie zuvor angeben im Umluftofen bei 80 bis 100 °C während 20 Minuten getrocknet. Neuderdings stehen auch anstelle von flüssigen Positiv-Resistmaterialien Positiv-Resistfolien zum Auflaminieren zur Verfügung. Mit diesem Verfahrensschritt ist der Matrixaufbau beendet.

Die Photoresistschichten 4 auf Vorder- und Rückseite werden nunmehr durch Masken mit den gewünschten Leiterzugstrukturen belichtet. Wegen der laufenden Änderung der Lampenintensität müssen die genauen Belichtungsparameter jeweils vor der Belichtung durch Versuchsreihen ermittelt werden. Bei der Anwendung von Positiv-Photoresistmaterial gemäss der Erfindung kehrt sich der Maskenkontrast gegenüber dem bisherigen Stand der Technik mit Negativ-Resistmaterialien um, d.h. die Maske ist im vorliegenden Verfahren korrekt negativ. Das bedeutet, dass die Maske nur noch an den wenigen Stellen späterer Leiterzüge lichtdurchlässig ist, was zur Folge hat, dass Verunreinigungen durch Fremdpartikel nur noch auf dem lichtdurchlässigen Teil der Maske, der weniger als 5% der Maskenfläche ausmacht, vorkommen können, während Verunreinigungen auf den nicht lichtdurchlässigen Teilen der Maske keine Rolle mehr spielen. Die Entwicklung der belichteten Photoresistschichten 4 erfolgt in einem Tauchverfahren mit einem wässrig alkalischen Entwickler auf der Basis von $Na_2SiO_3$ und $Na_3PO_4$ und etwas NaOH, der im Verhältnis 1:1 verdünnt ist. Die Entwicklertemperatur beträgt etwa 24 °C, die Entwicklerzeit ist durch Versuch zu ermitteln, da sie stark von der Belichtung abhängt. Als Ergebnis dieser Verfahrensschritte werden Photoresistmasken 4 mit einem der gewünschten Leiterzugstruktur entsprechenden Muster 5 erhalten.

Für das Ätzen der Sperrschichten 3 aus Aluminium durch die Photoresistmaske 4 hindurch sind zwei Verfahren anwendbar. Das Aluminium kann in einem nasschemischen Ätzverfahren in einer handelsüblichen Ätzmischung aus $H_3PO_4$, $HNO_3$, $H_2O$ im Verhältnis 80:16:4 mit einer Ätzrate von 3 bis 3,5 nm pro Sekunde bei 40 °C geätzt werden.

Hierbei wird vorteilhafter Weise eine Ätzendpunktsbestimmung anhand einer Laserinterferenzmessung durchgeführt. Die Sperrschicht 3 aus Aluminium kann auch in einem Trockenätzverfahren in einem Reaktor mit parallel angeordneten Plattenelektroden durchgeführt werden. Zum Ätzen werden halogenierte Ätzgase verwendet. Gute Ergebnisse können beispielsweise mit $CCl_4$, $CCl_2F_2$, $CBrF_3$, $CFCl_3$ mit 10 bis 20% Sauerstoffzusatz erzielt werden. Auch mit einer Mischung von 7,5 Vol.-% $SF_6$, 2,5 Vol.-% $Cl_2$ und 90 Vol.-% Helium wurden brauchbare Ergebnisse erzielt. Für alle Ätzgase müssen die Ätzbedingungen so eingestellt werden, dass ein möglichst grosses Ätzratenverhältnis zwischen Photoresistmaske und Aluminiumsperrschicht erzielt wird. In einer praktischen Ausführung wurde mit folgenden Ätzparametern gearbeitet:

| | |
|---|---|
| Leistungsdichte: | 0,2 Watt/cm²; |
| Partialdruck: | 12 bis 40 µbar; |
| Fluss: | 20 bis 40 cm³/Min.; |
| Ätzratenverhältnis | |
| Photoresist zu Aluminium: | 1:2 bis 1:4; |
| Ätzrate Aluminium: | 100 nm/Min. |

Auch hier erfolgt die Endproduktsbestimmung in vorteilhafter Weise durch laserinterferometrische Schichtdickenmessung (EEPD). Wenn die Aluminiumschicht 3 (Fig. 1) im Trockenätzverfahren durchgeätzt ist, wird auf Sauerstoff als Ätzgas umgeschaltet und die etwa 2 µm dicke Photoresistschicht 2 (Fig. 2) in der Weise reaktiv geätzt, dass ein Unterätzprofil 6 entsteht. Dieses ist eine Folge des Ätzdruckes. Das reaktive Ionenätzen der Schicht 2 erfolgt mit folgenden Parametern:

| | |
|---|---|
| Leistungsdichte: | 0,2 Watt/cm²; |
| Sauerstofffluss: | 30 cm³/Min.; |
| Druck: | 100–200 µbar; |
| Ätzrate: | 200 nm/Min. |

Anschliessend wird, ebenfalls mit Sauerstoff, aber mit anderen Ätzparametern durch die durch das Aluminium 3 definierte Öffnung vertikal ein Graben 7 in das Epoxidharz 1 geätzt. Für das vertikale Ätzen ist der niedrige Sauerstoffdruck verantwortlich. Die Grabentiefe von etwa 40 µm entspricht der späteren Leiterzugdicke. Die Gräben 7 in das Epoxidharz 1 können mit folgenden Parametern reaktiv geätzt werden:

| | |
|---|---|
| Leistungsdichte: | 0,2 Watt/cm²; |
| Fluss: | 200 cm³/Min.; |
| Druck: | 6 µbar; |
| Ätzrate: | 120 nm/Min. |

Alle Ätzraten im Rahmen der vorliegenden Erfindung stellen keine optimierten Ätzraten dar. Durch eine Optimierung der Anlagentechnik können wesentlich höhere Ätzraten erhalten werden.

Entsprechend dem eingeätzten Signalplan werden die Laminate 1 nunmehr gebohrt, um die Verbindungen zwischen Vorder- und Rückseite herzustellen. Das Herstellen der Bohrungen 8 (Fig. 3) erfolgt standardmässig auf handelsüblichen, numerisch gesteuerten Hochgeschwindigkeitsbohrmaschinen. Im Anschluss an das Bohren der Verbindungen zwischen Vorder- und Rückseite wird in einem Hochleistungs-Kathodenzerstäubungsverfahren mit magnetfeldunterstützter Gasentladungstechnik eine dünne Kupferschicht 9 auf die Oberfläche der in das Epoxidharz 1 geätzten Gräben 7 und der Bohrungen 8 sowie auf die Oberfläche der Aluminiumsperrschicht 3 aufgetragen. Der Auftrag der dünnen Kupferschicht 9 erfolgt auch auf der Rückseite der Platte auf die Oberfläche der Gräben in dem Epoxidharz und auf der Oberfläche der Aluminiumsperrschicht 3. Sie dient zur Aktivierung der Oberflächen für das stromlose Abscheiden von Kupfer. Zum Auftragen der Kupferschicht wird vorzugsweise eine Sputterdurchlaufanlage mit zwei sich gegenüberliegenden mit Kupfer bestückten Kathoden verwendet. Mit dieser Anlage werden Kupferschichten mit einer Schichtdicke zwischen 200 und 1000 nm, vorzugsweise zwischen 400 und 600 nm Schichtdicke aufgesputtert. Die so aufgebrachten Kupferschichten ersetzen die bisher üblichen auflaminierten Kupferfolien. Mit den Schichtdicken zwischen 400 und 600 nm werden bei der späteren stromlosen Verkupferung ausgezeichnete Haftungswerte bis zu 900 N/m erhalten. Wesentlich und hervorzuheben ist, dass die in der Photoresistschicht 2 erzeugte Unterätzung 6 (Fig. 2) ein Besputtern der Photoresistwände 2 mit Kupfer beim Aufbringen der Schicht 9 verhindert. Mit der Verkupferung der Oberflächen der Aluminiumschicht 3 und des Epoxidharzes werden auch die Oberflächen der Bohrlöcher 8 einwandfrei verkupfert.

Im nächsten Prozessschritt wird der Photoresist, der als Ablöseschicht 2 dient, und die diese bedeckende Aluminiumschicht 3 durch Tauchen in ein geeignetes Lösungsmittel, beispielsweise Aceton oder N-Butylacetat unter Durchblasen von Stickstoff abgehoben (nicht dargestellt). Zurück bleibt ein Epoxidharzlaminat 1 mit eingeätzten Leiterzuggräben, wobei die Wände der Gräben mit Kupfer besputtert sind. Das Laminat für eine Signalebene ist nunmehr vorbereitet für das stromlose Aufbringen von Kupfer nach dem Additivverfahren in den geätzten Leiterzuggräben. Hierzu werden die Laminate in ein Langzeitbad gebracht, beispielsweise in ein Kupferbad der Firma Photocircuits Kollmorgen, dessen Zusammensetzung in dem von Günther Herrmann herausgegebenen Handbuch der Leiterplattentechnik, 2. Auflage, Leuze-Verlag auf Seite 263 beschrieben ist. Das Aufwachsen der Leiterzüge beginnt gleichzeitig von allen Seiten, bis die eingeätzten Gräben völlig mit Kupfer gefüllt sind (Fig. 4). Die abgeschiedenen Leiterzüge weisen eine Schichtdicke im Bereich von 35 bis 50 µm auf. Beispielsweise 40 µm starke Leiterzüge werden in etwa 20 Stunden abgeschieden. Bei diesem Verfahren werden auch die Bohrlöcher mitverkupfert, welche eine leitende Verbindung zwischen den auf den Signalebenen aufgebrachten Leiterzügen in X- und Y-Richtung darstellen. Eventuell auf der übrigen Laminatoberfläche abgeschiedene Kupferinseln werden durch ein intensives, aber kurzzeitig angewendetes Ätzverfahren entfernt.

Nach dem zuvor beschriebenen Verfahren werden Epoxidharz-Signalebenen erhalten mit völlig planaren Oberflächen, die sich problemlos mit anderen Signalebenen, Energieversorgungsebenen oder Prepregs zu einer Platte zusammenlaminieren lassen.

## Patentansprüche

1. Verfahren zum Herstellen von gedruckten Schaltungen, bei denen metallische Leiterzugstrukturen in ein Isolierstoffsubstrat eingebettet sind und Vorder- und Rückseite mittels durchmetallisierter Löcher elektrisch leitend verbunden sind, gekennzeichnet durch folgende Verfahrensschritte:

1. Aufbauen einer Matrix durch
   a) Aufbringen einer Ablöseschicht (2) auf das Substrat (1) und Trocknen,
   b) Aufdampfen einer metallischen Sperrschicht (3) und
   c) Aufbringen einer Photoresistschicht (4) und Trocknen;
2. Belichten der Photoresistschicht (4) durch eine Negativmaske und Entwickeln zur Herstellung eines Positivbildes;
3. a) Ätzen einer Maske in die Sperrschicht (3) mittels eines Nass- oder Trockenätzverfahrens,
   b) Ätzen der Ablöseschicht (2) und
   c) vertikales Ätzen von Gräben (7) in das Isolierstoffsubstrat (1);
4. Bohren der Löcher (8) gemäss eingeätztem Signalplan;
5. Magnetfeldunterstützte Hochleistungskathodenzerstäubung zum Aufbringen einer dünnen Kupferschicht (9) auf die Oberflächen der Gräben (7), der Bohrlöcher (8) und der Sperrschicht (3);
6. Abheben der Ablöseschicht (2) samt der sie bedeckenden Sperrschicht (3) durch Tauchen in ein geeignetes Lösungsmittel;
7. Stromlose Abscheidung von Kupfer in den in das Isolierstoffsubstrat eingeätzten Gräben (7) und den Bohrlöchern (8) unter Erhalt einer Signalebene mit planarer Oberfläche.

2. Verfahren nach Anspruch 1, dadurch gekennzeichnet, dass zur Herstellung der Ablöseschicht (2) und der Photoresistschicht (4) Positivphotoresistmaterialien verwendet werden.

3. Verfahren nach Anspruch 1, dadurch gekennzeichnet, dass zur Herstellung der Sperrschicht (3) Aluminium in einer Schichtdicke von 200 bis 500 nm kalt aufgesputtert oder aufgedampft wird.

4. Verfahren nach den Ansprüchen 1 und 3, dadurch gekennzeichnet, dass die Sperrschicht aus Aluminium mit einem halogenierten Ätzgas unter Sauerstoffzusatz trockengeätzt wird.

5. Verfahren nach Anspruch 1, dadurch gekennzeichnet, dass die Ablöseschicht (2) in der Weise mit Sauerstoff trockengeätzt wird, dass ein Unterätzprofil (6) entsteht.

6. Verfahren nach einem oder mehreren der Ansprüche 1 bis 5, dadurch gekennzeichnet, dass die zur Aktivierung der Oberflächen für die folgende stromlose Kupferabscheidung vorgesehene Kupferschicht (9) in einer Schichtdicke zwischen 200 und 1000 nm, vorzugsweise zwischen 400 und 600 nm aufgesputtert wird.

## Revendications

1. Procédé pour fabriquer des circuits imprimés, dans lesquels des structures métalliques de voies conductrices sont incrustées dans un substrat en matériau isolant et la face avant et la face arrière sont reliées d'une manière électriquement conductrice à l'aide de trous métallisées, caractérisé par les phases opératoires suivantes:

1. formation d'une matrice par
   a) dépôt d'une couche pouvant être éliminée (2) sur le substrat (1) et séchage,
   b) dépôt par évaporation d'une couche de blocage métallique (3), et
   c) dépôt d'une couche formant résine photosensible (4) et séchage;
2. éclairage de la couche de résine photosensible (4) moyennant l'interposition d'un masque négatif et développement pour la fabrication d'une image positive;
3. a) aménagement d'un masque, par corrosion, dans la couche de blocage (3) au moyen d'un procédé de corrosion par voie humide ou à sec,
   b) corrosion de la couche pouvant être éliminée (2), et
   c) aménagement, par corrosion verticale, de sillons (7) dans le substrat en matériau isolant (1);
4. perçage des trous (8) conformément au schéma d'acheminement de signaux, aménagé par corrosion;
5. pulvérisation cathodique de grande puissance, assistée par un champ magnétique, pour le dépôt d'une mince couche de cuivre (9) sur les surfaces des sillons (7), des trous de perçage (8) et de la couche de blocage (3);
6. enlèvement de la couche pouvant être éliminée (2) ainsi que de la couche de blocage (3) qui la recouvre, par immersion dans un solvant approprié;
7. dépôt sans courant de cuivre dans les sillons (7), aménagés par corrosion dans le substrat en matériau isolant, et dans les trous percés (8) avec obtention d'un plan de transmission des signaux comportant une surface plane.

2. Procédé selon la revendication 1, caractérisé en ce que pour fabriquer la couche pouvant être éliminée (2) et la couche de résine photosensible (4), on utilise des matériaux formés de résines photosensibles à effet positif.

3. Procédé selon la revendication 1, caractérisé en ce que pour fabriquer la couche de blocage (3), on pulvérise à froid ou on dépose par évaporation de l'aluminium en formant une couche d'une épaisseur comprise entre 200 et 500 nm.

4. Procédé selon les revendications 1 et 3, caractérisé en ce qu'on réalise une corrosion à sec de la couche de blocage en aluminium en utilisant un gaz corrosif halogéné avec une addition d'oxygène.

5. Procédé selon la revendication 1, caractérisé en ce que l'on réalise une corrosion à sec de la couche (2) pouvant être éliminée, avec de l'oxygène de manière à faire apparaître un profil de corrosion sous-jacente (6).

6. Procédé selon une ou plusieurs des revendications 1 à 5, caractérisé en ce qu'on dépose par pulvérisation la couche de cuivre (9), prévue pour activer la surface pour le dépôt ultérieur de cuivre sans courant, avec une épaisseur de couche comprise entre 200 et 1000 nm et de préférence entre 400 et 600 nm.

## Claims

1. Process for producing printed circuits wherein metallic conductor structures are embedded in an insulating substrate and front and back sides are conductively connected by means of plated through holes, comprising the following process steps:

1. producing a matrix by
a) depositing a lift-off layer (2) on the substrate (1) and drying,
b) evaporating a metallic barrier layer (3) and
c) depositing a photoresist layer (4) and drying;
2. exposing the photoresist layer (4) through a negative mask and developing for producing a positive image;
3. a) etching a mask into the barrier layer (3) by means of a wet or a dry etch process;
b) etching the lift-off layer (2) and
c) vertically etching trenches (7) into the insulating substrate (1);
4. drilling through holes (8) according to the etched signal plan;
5. magnetic field enhanced high-energy cathode sputtering for depositing a thin copper layer (9) on the surfaces of the trenches (7), the through holes (8) and the barrier layer (3);
6. removing the lift-off layer (2) along with the barrier layer (3) covering it by immersion in a suitable solvent;
7. electrolessly depositing copper in the trenches (7) etched into the insulating substrate and the through holes (8), yielding a signal core with a planar surface.

2. Process according to claim 1, characterized in that for producing the lift-off layer (2) and the photoresist layer (4), positive photoresist materials are used.

3. Process according to claim 1, characterized in that for producing the barrier layer (3), aluminium with a layer thickness from 200 to 500 nm is cold-sputtered or evaporated.

4. Process according to claim 1 and 3, characterized in that the barrier layer of aluminium is dry-etched by means of a halogenated etch gas, adding oxygen.

5. Process according to claim 1, characterized in that the lift-off layer (2) is dry-etched by means of oxygen such that an undercut (6) occurs.

6. Process according to any one or a combination of claims 1 to 5, characterized in that for activating the surfaces for the subsequent electroless copper deposition, a copper layer (9) is sputtered with a layer thickness between 200 and 1000 nm, preferably between 400 to 600 nm.

0 127 689

1 / 1

FIG. 1

FIG. 2

FIG. 3

FIG. 4